# FASCICULE DE BREVET EUROPEEN

(11) **EP 0 815 284 B1**
(45) Date de publication et mention de la délivrance du brevet: **24.07.2002**
(21) Numéro de dépôt: 96905921.1
(22) Date de dépôt: 06.03.1996
(51) Int. Cl.: C23C 16/50, C23C 16/44

(54) **PROCEDE ET APPAREIL POUR LE DEPOT ASSISTE PAR PLASMA SUR UN SUBSTRAT A DEUX FACES**
VERFAHREN UND VORRICHTUNG ZUR DOPPELSEITIGEN PLASMA BECHICHTUNG EINES SUBSTRATS
METHOD AND APPARATUS FOR PLASMA DEPOSITION ON A DOUBLE-SIDED SUBSTRATE

(30) Priorité: 07.03.1995 FR 9502617
(43) Date de publication de la demande: 07.01.1998
(73) Titulaire: ESSILOR INTERNATIONAL (Compagnie Générale d'Optique), F-94220 Charenton-le-Pont (FR)
(72) Inventeur: BOSMANS, Richard, F-94880 Noiseau (FR); CHEAIB, Mehdi, F-91940 Les Ullis (FR)
(74) Mandataire: CABINET BONNET-THIRION
(86) Numéro de dépôt international: FR9600352
(87) Numéro de publication internationale: WO9627690

(56) Documents cités:
- EP-A- 0 188 206
- EP-A- 0 359 264
- EP-A- 0 502 385
- EP-A- 0 563 748
- WO-A-95/26427
- PATENT ABSTRACTS OF JAPAN vol. 018, no. 647 (C-1283), 8 Décembre 1994 & JP,A,06 248458 (HITACHI LTD), 6 Septembre 1994,
- PATENT ABSTRACTS OF JAPAN vol. 012, no. 219 (C-506), 22 Juin 1988 & JP,A,63 014876 (MITSUBISHI HEAVY IND LTD), 22 Janvier 1988,
- PATENT ABSTRACTS OF JAPAN vol. 017, no. 110 (E-1329), 8 Mars 1993 & JP,A,04 293235 (KOKUSAI ELECTRIC CO LTD), 16 Octobre 1992,
- IBM TECHNICAL DISCLOSURE BULLETIN, vol. 31, no. 10, NEW YORK, US, pages 314-317, XP000049075 ANONYMOUS: "High Rate Plasma Deposition System"

## Description

La présente invention concerne d'une manière générale le dépôt d'au moins une couche mince sur un substrat à deux faces lorsque, pour assister ce dépôt, il est mis en oeuvre, suivant une technique communément appelée PECVD (selon l'appellation anglaise "Plasma Enhanced Chemical Vapor Deposition"), un plasma créé par une décharge électrique dans un gaz à basse pression en coopération avec lequel interviennent un ou plusieurs fluides précurseurs dont les produits de réaction dans le plasma donnent naissance au dépôt recherché.

Elle vise plus particulièrement, mais non nécessairement exclusivement, le cas où le substrat à deux faces à traiter est une lentille ophtalmique destinée à être montée dans une quelconque monture de lunettes.

Les lentilles ophtalmiques sont de plus en plus fréquemment l'objet de divers traitements pour en améliorer les performances.

Par exemple, elles peuvent être l'objet d'un traitement antireflet et/ou d'un traitement antiultraviolet et/ou d'un traitement destiné à en faciliter le nettoyage, et, notamment lorsqu'il s'agit de lentilles ophtalmiques en matériau organique, elles peuvent également être l'objet d'un traitement antiabrasion ou antirayure.

Ces traitements impliquent toujours le dépôt d'au moins une couche mince sur l'une et l'autre des deux faces traitées.

S'agissant d'un traitement antireflet, une ou plusieurs couches minces sont nécessaires, et il s'agit en pratique de couches minérales, en oxyde de silicium, de tantale, de titane ou de zirconium par exemple, ou encore en fluorure de magnésium, dont le dépôt est à ce jour généralement réalisé par évaporation thermique sous vide.

S'agissant d'un traitement antiabrasion, qui implique le dépôt d'un vernis, en général un polysiloxane, il est le plus souvent procédé par voie liquide, par exemple au trempé ou par centrifugation.

Il a, par ailleurs, été déjà proposé d'appliquer dans ce cas aux lentilles ophtalmiques la technique PECVD déjà connue antérieurement pour d'autres produits.

Cette technique PECVD a notamment pour avantage de se satisfaire si désiré d'une assez grande diversité en ce qui concerne le produit susceptible d'être déposé.

Le document EP A 188 206 décrit un procédé de traitement PECVD conforme au préambule de la revendication 1. Dans le procédé décrit par ce document, le substrat à traiter est immergé dans un plasma, en étant pour ce faire disposé entre deux électrodes propres à l'excitation de la décharge nécessaire, en l'espèce une décharge haute fréquence.

Cette disposition a pour avantage de permettre un traitement simultané des deux faces du substrat.

Mais elle présente des inconvénients, qui sont les suivants.

Tout d'abord, la présence d'électrodes peut conduire de manière intempestive à une certaine contamination des couches déposées.

En outre, les dispositions constructives nécessaires, liées notamment à la présence d'électrodes, se prêtent mal à un éventuel traitement continu en ligne ou à un traitement pièce par pièce, et, au contraire, elles conduisent quasi inévitablement à un traitement discontinu, par fournée, au détriment de la productivité.

De surcroît, le fait que le substrat soit immergé dans le plasma limite le choix du matériau pouvant constituer ce substrat.

En effet, la température des espèces gazeuses et le rayonnement ultraviolet qui sont généralement rencontrés au sein d'un milieu plasma sont susceptibles de détériorer le substrat, en particulier lorsque celui-ci est réalisé en matériau organique.

La présente invention a d'une manière générale pour objet une disposition qui, tout en permettant la mise en oeuvre de la technique PECVD, est avantageusement exempte de ces inconvénients pour permettre en particulier le traitement des substrats en matière organique avec un risque réduit de déterioration.

Ce but est atteint grâce aux caractéristiques énoncées dans la revendication 1.

Ainsi, par une mise en oeuvre du type dit en "post-décharge", le substrat à traiter peut avantageusement être maintenu en dehors du milieu plasma, à une distance de ce dernier qui peut être ajustée, ce qui permet de limiter la température et l'intensité du rayonnement ultraviolet auxquelles il est soumis, et ce qui permet donc d'envisager l'application de la technique PECVD à un quelconque substrat en matière organique, avec un risque de détérioration de celui-ci notablement réduit.

Pour minimiser encore un tel risque de détérioration, les plasmas mis en oeuvre interviennent préférentiellement en mode pulsé.

Un tel mode d'intervention, qui peut aisément être mis en oeuvre dans le cas de décharges excitées à des fréquences micro-ondes, permet avantageusement d'entretenir une efficacité de réaction chimique élevée, tout en alimentant ces décharges avec une puissance électrique réduite, et cette dernière ne génère en conséquence qu'une élévation de température également réduite.

Suivant l'invention, il est mis en oeuvre deux plasmas distincts, à raison d'un par face du substrat à traiter, et, en pratique, il s'agit de deux plasmas dont les paramètres de mise en oeuvre peuvent être avantageusement, mais non nécessairement, identiques.

Lorsque les plasmas sont identiques, le dépôt obtenu se fait avantageusement dans les mêmes conditions sur l'une et l'autre des deux faces du substrat.

Mais, les plasmas étant distincts, il est avantageusement possible, en variante, de contrôler indépendamment l'un de l'autre les dépôts respectifs sur les deux faces.

De façon préférentielle, mais non nécessairement obligatoirement, les décharges électriques correspondantes sont excitées à des fréquences micro-ondes.

Il est en effet connu que la densité électronique dans une décharge excitée à une telle fréquence micro-ondes est largement supérieure à celle d'une décharge excitée à d'autres fréquences.

Cette densité électronique est typiquement de l'ordre de 10¹² électrons/cm³ pour une fréquence micro-ondes, contre, par exemple, 10⁹ à 10¹⁰ électrons/cm³ pour une radiofréquence.

Cette caractéristique confère avantageusement aux décharges excitées à des fréquences micro-ondes une plus grande efficacité de dissociation du gaz et des fluides précurseurs, et, par là-même, une plus grande vitesse de dépôt possible.

De plus, un tel mode d'excitation ne nécessitant aucune électrode pour sa mise en oeuvre, tout risque de contamination se trouve ainsi évité.

Enfin, un processus continu de traitement en ligne ou pièce par pièce est avantageusement envisageable.

Les caractéristiques et avantages de l'invention ressortiront d'ailleurs de la description qui va suivre, à titre d'exemple, en référence aux dessins schématiques annexés sur lesquels :
la figure 1 est, avec une coupe locale, une vue de face d'un réacteur propre à la mise en oeuvre du procédé suivant l'invention ;
la figure 2 est une vue de dessus de ce réacteur, suivant la flèche II de la figure 1 ;
la figure 3 en est, à échelle supérieure, une vue partielle en coupe axiale, suivant la ligne III-III de la figure 1.

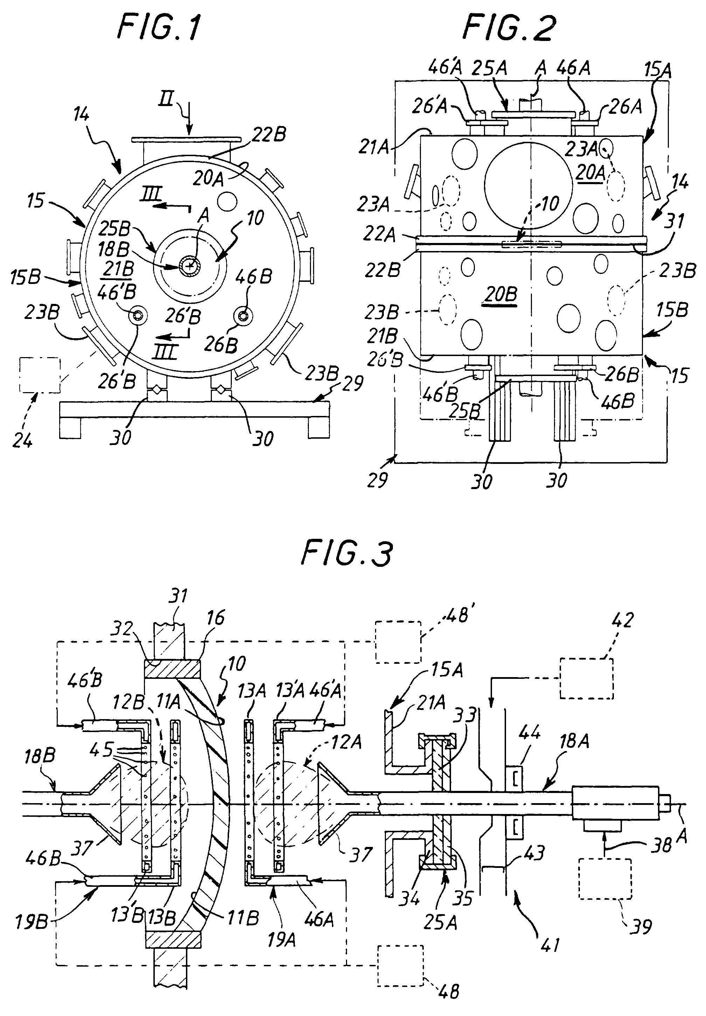

Tel qu'illustré sur ces figures, et plus particulièrement sur la figure 3, il s'agit, globalement, du traitement d'un substrat 10 présentant essentiellement deux faces, telles que, par exemple, une face avant 11A et une face arrière 11B.

Dans la forme de réalisation représentée, ce substrat 10 est une lentille ophtalmique.

Il se présente donc sous la forme d'un palet.

En pratique, dans la forme de réalisation représentée, sa face avant 11A est convexe, et sa face arrière 11B concave.

Le substrat 10 ainsi constitué est par exemple en matériau organique.

Le traitement à appliquer à ce substrat 10 implique le dépôt d'au moins une quelconque couche mince sur l'une et l'autre des deux faces 11A, 11B de celui-ci.

De manière connue en soi, il est mis en oeuvre, pour ce faire, un plasma, en coopération avec lequel intervient au moins un fluide précurseur dont les produits de réaction dans le plasma donnent naissance au dépôt recherché.

Suivant l'invention, pour un traitement simultané des deux faces 11A, 11B du substrat 10, il est mis en oeuvre, tel que schématisé en traits interrompus sur la figure 3, deux plasmas 12A, 12B distincts, l'un intervenant du côté de l'une de ces faces 11A, 11B, en l'espèce la face avant 11A, et l'autre intervenant du côté de l'autre de celles-ci, en l'espèce la face arrière 11B.

En pratique, ces plasmas 12A, 12B peuvent être identiques.

Autrement dit, ils comportent alors les mêmes composants, et relèvent d'un même processus de formation.

Par exemple, parmi leurs composants interviennent, notamment, et de manière usuelle, les gaz suivants : Ar, O₂, N₂, N₂O, NH₃ .... etc.

Par exemple, également, et préférentiellement, les décharges électriques donnant naissance à ces plasmas 12A, 12B sont excitées à des fréquences micro-ondes.

Suivant des dispositions qui, bien connues par elles-mêmes, ne seront pas décrites ici, les plasmas 12A, 12B ainsi constitués interviennent préférentiellement en mode pulsé.

Préférentiellement, également, leur mise en oeuvre est du type dit en "post-décharge".

Autrement dit, et tel que schématisé en traits interrompus sur la figure 3, il est fait en sorte que le substrat 10 à traiter soit maintenu en dehors du milieu plasma, chacun des plasmas 12A, 12B s'arrêtant à distance de lui.

De manière connue en soi, le fluide précurseur à mettre corollairement en oeuvre est un gaz.

Par exemple, lorsque le produit à déposer est un oxyde de silicium (SiO₂), un nitrure de silicium (Si₃ N₄), ou un oxynitrure de silicium (Siₓ O_{y} N_{z}), le fluide précurseur correspondant peut être du silane, ou du hexaméthyldisiloxane.

Lorsque le produit à déposer est un oxyde de titane (TiO₂), le fluide précurseur peut par exemple être un produit organométallique, tel que du tétra-iso-propyl titanate.

Il peut également, dans ce cas, être du tétrachlorure de titane.

Quoi qu'il en soit, pour l'intervention d'un tel fluide précurseur, il est mis en oeuvre, suivant l'invention, et tel que décrit plus en détail ultérieurement, au moins un anneau, qui, établi à distance du substrat, globalement parallèlement à celui-ci, est propre à la diffusion de ce fluide précurseur.

Dans la forme de réalisation représentée, il est ainsi mis en oeuvre, parallèlement l'un à l'autre, et à distance l'un de l'autre, pour chacune des deux faces 11A, 11B du substrat 10, deux anneaux 13A, 13'A, 13B, 13'B, qui, propres à une telle diffusion, correspondent chacun respectivement à deux fluides précurseurs distincts.

Ces deux fluides précurseurs peuvent intervenir isolément ou concurremment.

D'une manière plus générale, le nombre de fluides précurseurs ainsi susceptibles d'intervenir peut être supérieur à deux.

Il est alors mis en oeuvre parallèlement les uns aux autres, un nombre d'anneaux 13A, 13'A ..., 13B, 13'B ... supérieur à deux.

De manière plus précise, il est mis en oeuvre, suivant l'invention, pour le traitement recherché du substrat 10, c'est-à-dire pour le dépôt d'au moins une couche mince sur celui-ci, un réacteur 14 comportant une enceinte de traitement 15 formée de deux demi-enceintes 15A, 15B, chacune en forme de cloche, qui, alignées suivant un axe A commun, tel que schématisé par un trait interrompu sur les figures, sont ouvertes l'une vers l'autre et sont susceptibles d'être accolées de manière étanche l'une à l'autre par leur débouché, avec, à leur interface, un porte-substrat 16.

Dans la forme de réalisation représentée, l'axe A est horizontal.

L'une, au moins, des deux demi-enceintes 15A, 15B, en l'espèce la demi-enceinte 15B, est mobile, pour donner accès au porte-substrat 16, et, pour chacune d'elles, il est prévu, d'une part, un dispositif d'injection 18A, 18B, pour l'intervention du plasma 12A, 12B correspondant, et, d'autre part, pour la diffusion du ou des fluides précurseurs, un dispositif de diffusion 19A, 19B, comportant, comme précédemment indiqué, au moins un, et, en pratique, au moins deux anneaux 13A, 13'A, 13B, 13'B.

Dans la forme de réalisation représentée, les deux demi-enceintes 15A, 15B sont globalement identiques l'une à l'autre.

Elles sont chacune formées d'une paroi latérale cylindrique 20A, 20B, de section transversale circulaire, et d'une paroi transversale de fond 21A, 21B.

A leur débouché, la paroi latérale cylindrique 20A, 20B présente une bride 22A, 22B, pour leur solidarisation l'une à l'autre.

Sur la paroi latérale cylindrique 20A, 20B interviennent un certain nombre de piquages, et, notamment, au moins un piquage 23A, 23B propre à l'intervention d'un groupe de pompage 24 schématisé en traits interrompus sur la figure 1.

Sur la paroi transversale de fond 21A, 21B interviennent, par ailleurs, d'une part, un piquage central 25A, 25B, pour l'intervention du dispositif d'injection 18A, 18B, et, d'autre part, des piquages latéraux 26A, 26'A, 26B, 26'B, pour la desserte du dispositif de diffusion 19A, 19B.

Globalement, cette enceinte de traitement 15 est portée par un plancher 29, formant bâti.

La demi-enceinte 15A est fixe sur ce plancher 29.

La demi-enceinte 15B y est montée mobile sur des rails 30 parallèles à l'axe A suivant lequel elle est alignée avec la demi-enceinte 15A fixe.

Globalement, la demi-enceinte 15B est ainsi montée mobile entre une position avancée, pour laquelle elle est aboutée à la demi-enceinte 15A fixe, tel que représenté en trait continu sur la figure 2, et une position reculée, pour laquelle, au contraire, et tel que schématisé en traits interrompus sur la figure 2, elle est écartée de cette demi-enceinte 15A fixe.

Dans la forme de réalisation représentée, le porte-substrat 16 est porté par un écran d'isolation 31 inséré de manière étanche entre les deux demi-enceintes 15A, 15B, entre les brides 22A, 22B de celles-ci, cet écran d'isolation 31 présentant, dans sa zone centrale, une ouverture 32 à la faveur de laquelle intervient le porte-substrat 16.

Par exemple, et tel que représenté, ce porte-substrat 16 est simplement constitué d'une bague, qui, formant bague d'adaptation entre l'écran d'isolation 31 et le substrat 10, est engagée, à frottement doux, dans l'ouverture 32 de l'écran d'isolation 31, et dans laquelle est engagé, à frottement doux, le substrat 10.

Lorsque, comme en l'espèce, l'axe A commun à l'ensemble est horizontal, le porte-substrat 16 s'étend verticalement, et il en est donc de même du substrat 10 à traiter, ce qui permet avantageusement de minimiser un éventuel problème de poussières dans le réacteur 14.

Dans la forme de réalisation représentée, le dispositif d'injection 18A, 18B est, pour chaque demi-enceinte 15A, 15B, formé par un tube disposé axialement, suivant l'axe A.

Il s'agit, en pratique, d'un tube de quartz, qui traverse, axialement, à étanchéité, le piquage central 25A, 25B correspondant.

Par exemple, et tel que représenté sur la figure 3 pour le dispositif d'injection 18A, le tube de quartz correspondant est, pour ce faire, porté par une plaque de quartz 33, qui en est dûment solidaire, et qui, intervenant transversalement entre ses extrémités, est insérée entre la bride 34 du piquage central 25A et une contre-bride 35 dûment solidarisée à cette bride 34.

A son extrémité interne, le tube de quartz constituant un dispositif d'injection 18A, 18B est équipé d'un divergent 37, lui-même en quartz.

A son extrémité externe, est piquée, latéralement, une arrivée de gaz 38, en provenance d'un ensemble d'injection 39 propre à délivrer les gaz nécessaires.

Quoi qu'il en soit, à l'extérieur de chaque demi-enceinte 15A, 15B, le tube de quartz constituant un dispositif d'injection 18A, 18B est entouré d'un excitateur 41, qui, tel que schématisé en traits interrompus sur la figure 3, est dûment desservi par une source d'excitation 42.

Préférentiellement, cette source d'excitation 42 est un générateur d'énergie micro-ondes.

Elle est par exemple du type à magnétron.

Dans la forme de réalisation schématisée à la figure 3, l'excitateur 41, de type "surfaguide", connu en soi, a un court-circuit 43 pour permettre un réglage de la phase du champ électromagnétique et une optimisation du transfert de l'énergie micro-ondes dans le plasma 12A, 12B.

Il s'agit en outre d'un excitateur dissymétrique, équipé, à son dos, d'un court-circuit mobile 44, pour favoriser l'extension du plasma 12A, 12B du côté de la demi-enceinte 15A, 15B.

Un tel excitateur 41 étant bien connu par lui-même, et ne relevant pas en propre de la présente invention, il ne sera pas décrit plus en détail ici.

On pourra par exemple se reporter à son sujet à la description qui en est faite dans le brevet français No 74 36378 ou dans le brevet français No 75 33425.

Les dispositions qui précèdent sont identiques pour l'une et l'autre des deux demi-enceintes 15A, 15B.

C'est la raison pour laquelle elles n'ont été représentées sur la figure 3 que pour la seule demi-enceinte 15A.

Les anneaux 13A, 13'A, 13B, 13'B constituant par ailleurs les dispositifs de diffusion 19A, 19B sont, en pratique, des anneaux creux, par exemple de section transversale quadrangulaire ou circulaire, qui, présentant de place en place des perçages 45, par exemple sur leur contour intérieur, ont leur volume intérieur raccordé à une canalisation d'alimentation 46A, 46'A, 46B, 46'B traversant à étanchéité les piquages latéraux 26A, 26'A, 26B, 26'B correspondants.

Tel que schématisé en traits interrompus sur la figure 3, pour l'intervention de l'un et/ou de l'autre de deux fluides précurseurs, les canalisations d'alimentation 46A, 46B sont reliées à un même ensemble d'injection de fluide précurseur 48 correspondant à un premier de ces fluides précurseurs, et, parallèlement, les canalisations d'alimentation 46'A, 46'B sont elles-mêmes reliées à un même ensemble d'injection de fluide précurseur 48' correspondant au deuxième de ceux-ci.

Globalement, les deux anneaux 13A, 13'A, 13B, 13'B d'un dispositif de diffusion 19A, 19B s'étendent entre le substrat 10 et le dispositif d'injection 18A, 18B correspondant.

En service, la pression de dépôt, c'est-à-dire la pression du ou des gaz dans l'enceinte où se réalise le plasma, et donc dans le réacteur 14, peut par exemple s'étendre entre 30 mtorr et quelques torrs.

Conjointement, le débit gazeux peut être asservi à une vanne de régulation de la vitesse de pompage et par exemple s'étendre de 0 à 1000 sccm ("standard cubic centimeter per minute").

A titre d'exemple non limitatif, il sera précisé ci-après que, s'agissant du dépôt d'une couche d'oxyde de silicium (SiO₂) à partir de silane (SiH₄), de bons résultats ont été obtenus dans les conditions suivantes :

| | |
|---|---|
| débit de SiH₄ | 20 sccm |
| débit de O₂ | 100 sccm |
| puissance micro-ondes | 400 watts |
| fréquence micro-ondes | 2,45 gigahertz |
| pression de dépôt | 100 mtorr |

Avec de telles conditions, il est possible d'atteindre une vitesse de dépôt de l'ordre de 300 nm/mn.

Si désiré, il est possible également de mettre en oeuvre un système de gestion et d'injection des fluides précurseurs à vitesse de commutation élevée, pour permettre de changer rapidement la nature du produit déposé et/ou de faire varier l'indice de réfraction dans la couche formée.

La présente invention ne se limite d'ailleurs pas aux formes de réalisation et de mise en oeuvre décrites et représentées, mais englobe toute variante d'exécution.

En particulier, bien que, pour les raisons exposées, une excitation à des fréquences micro-ondes des décharges électriques nécessaires soit préférentielle, une excitation de ces décharges électriques dans la gamme des radiofréquences reste envisageable, par exemple à 13,56 mégahertz.

En effet, un tel mode d'excitation permet également un fonctionnement sans électrode, en post-décharge et en mode pulsé.

## Revendications

1. Procédé pour le dépôt d'au moins une couche mince sur un substrat à deux faces, du genre suivant lequel on met en oeuvre un plasma en coopération avec lequel intervient au moins un fluide précurseur dont les produits de réaction dans le plasma donnent naissance au dépôt recherché, et pour un traitement simultané des deux faces (11A, 11B) du substrat (10), on met en oeuvre deux plasmas (12A, 12B) distincts, l'un intervenant du côté d'une desdites faces (11A, 11B), l'autre intervenant du côté de l'autre de celles-ci, **caractérisé en ce que**, s'agissant du traitement d'un substrat (10) en matériau organique, on maintient le substrat (10) en dehors du milieu plasma par un traitement du type dit "en post-décharge".

2. Procédé suivant la revendication 1 **caractérisé en ce que** on met en oeuvre deux plasmas (12A, 12B) dont les paramètres de mise en oeuvre sont identiques.

3. Procédé suivant l'une quelconque des revendications 1 à 2, **caractérisé en ce que**, on fait intervenir les plasmas (12A, 12B) en mode pulsé.

4. Procédé suivant l'une quelconque des revendications 1 à 3, **caractérisé en ce que**, s'agissant d'un substrat (10) se présentant sous forme d'un palet, on met en oeuvre, pour l'intervention du fluide précurseur, au moins un anneau (13A, 13'A, 13B, 13'B), qui, établi à distance du substrat (10), globalement parallèlement à celui-ci, est propre à la diffusion de ce fluide précurseur.

5. Procédé suivant l'une quelconque des revendications 1 à 4, **caractérisé en ce que** l'excitation de la décharge électrique créant le plasma (12A, 12B) est faite à des fréquences micro-ondes.

6. Procédé suivant l'une quelconque des revendications 1 à 4, **caractérisé en ce que** l'excitation de la décharge électrique créant le plasma (12A, 12B) est faite à des radiofréquences.

7. Utilisation d'un appareillage pour la mise en oeuvre d'un procédé conforme à l'une quelconque des revendications 1 à 6, appareillage **caractérisé en ce qu'**il comporte une enceinte de traitement (15) formée de deux demi-enceintes (15A, 15B) en forme de cloche, qui, alignées suivant un axe (A) commun, sont susceptibles d'être accolées de manière étanche l'une à l'autre par leur débouché, avec, à leur interface, un porte-substrat (16), et dont une (15B), au moins, est mobile, pour donner accès audit porte-substrat (16), avec, pour chaque demi-enceinte (15A, 15B), un dispositif d'injection (18A, 18B), pour l'intervention d'un plasma (12A, 12B), et un dispositif de diffusion (19A, 19B), pour celle d'au moins un fluide précurseur, et **en ce que**, pour chaque demi-enceinte (15A, 15B), le dispositif d'injection (18A, 18B) est formé par un tube disposé axialement et le dispositif de diffusion (19A, 19B) comporte au moins un anneau (13A, 13'A, 13B, 13'B) creux qui est coaxial au tube d'injection (18A, 18B) et qui, présentant de place en place des perçages (45), a son volume intérieur raccordé à une canalisation d'alimentation (46A, 46'A, 46B, 46'B) et est établi à distance du porte-substrat (16), parallèlement à celui-ci.

8. Utilisation d'un appareillage suivant la revendication 7, appareillage **caractérisé en ce que**, la demi-enceinte (15B) mobile est montée coulissante sur des rails (30) parallèles à l'axe (A) suivant lequel elle est alignée avec l'autre demi-enceinte (15A).

9. Utilisation d'un appareillage suivant l'une quelconque des revendications 7, 8, appareillage **caractérisé en ce que** l'autre demi-enceinte (15A) est fixe.

10. Utilisation d'un appareillage suivant l'une quelconque des revendications 7 à 9, appareillage **caractérisé en ce que** le porte-substrat (16) est porté par un écran d'isolation (31) inséré de manière étanche entre les deux demi-enceintes (15A, 15B), ledit écran d'isolation (31) présentant dans sa zone centrale une ouverture (32) à la faveur de laquelle intervient le porte-substrat (16).

11. Utilisation d'un appareillage suivant l'une quelconque des revendications 7 à 10, appareillage **caractérisé en ce que** le porte-substrat (16) s'étend verticalement.

12. Utilisation d'un appareillage suivant l'une des revendications 7 à 11, appareillage **caractérisé en ce que**, à son extrémité interne, le tube formant le dispositif d'injection (18A, 18B) est équipé d'un divergent (37).

13. Utilisation d'un appareillage suivant l'une quelconque des revendications 7 à 12, appareillage **caractérisé en ce que**, à l'extérieur de chaque demi-enceinte (15A, 15B), le tube formant le dispositif d'injection (18A, 18B) est entouré par un excitateur (41).

14. Utilisation d'un appareillage suivant l'une des revendications 7 à 13, appareillage **caractérisé en ce que** le dispositif de diffusion (19A, 19B) comporte, parallèlement les uns aux autres, au moins deux anneaux (13A, 13'A, 13B, 13'B).

## Patentansprüche

1. Verfahren zur Fällung von zumindest einer Dünnschicht an einem Substrat mit zwei Flächen, vom Typ, bei welchem man ein Plasma einsetzt, in Wechselwirkung von welchem zumindest ein Vorläuferfluid interveniert, dessen Reaktionsprodukte in dem Plasma die gewünschte Fällung oder den gewünschten Niederschlag veranlassen, wobei man zur gleichzeitigen Behandlung der zwei Flächen (11A, 11B) des Substrates (10) zwei distinkte Plasma (12A, 12B) verwendet, wobei eines an der einen Seite der Flächen (11A, 11B) und das andere an der anderen Seite davon vorliegt, **dadurch gekennzeichnet, daß** es sich um die Behandlung eines Substrates (10) aus organischem Material handelt, wobei man das Substrat (10) außerhalb des Plasmamilieus in einer Behandlung von sogenanntem "Nachentladetyp" beibehält.

2. Verfahren nach Anspruch 1, **dadurch gekennzeichnet, daß** man zwei Plasma (12A, 12B) verwendet, deren Betriebsparameter identisch sind.

3. Verfahren nach einem der Ansprüche 1 und 2, **dadurch gekennzeichnet, daß** man die Plasma (12A, 12B) in gepulstem Modus vorsieht.

4. Verfahren nach einem der Ansprüche 1 bis 3, **dadurch gekennzeichnet, daß** es sich um ein Substrat (10) handelt, welches in der Form eines Palets oder Rohlinges vorliegt, wobei man zur Einwirkung des Vorläuferfluids zumindest einen Ring (13A, 13'A, 13B, 13'B) verwendet, welcher einen Abstand zu dem Substrat (10) generell parallel diesbezüglich bereitstellt und zur Diffusion des Vorläuferfluids geeignet ist.

5. Verfahren nach einem der Ansprüche 1 bis 4, **dadurch gekennzeichnet, daß** die Erregung der elektrischen Entladung, die das Plasma (12A, 12B) erzeugt, durch Mikrowellenfrequenzen erzielt wird.

6. Verfahren nach einem der Ansprüche 1 bis 4, **dadurch gekennzeichnet, daß** die Erregung oder Anregung der elektrischen Entladung, die das Plasma (12A, 12B) erzeugt, mit Hochoder Radiofrequenzen erzeugt wird.

7. Verwendung eines Gerätes zum Durchführen eines Verfahrens gemäß einem der Ansprüche 1 bis 6, wobei das Gerät **dadurch gekennzeichnet ist, daß** es ein Behandlungsgehäuse (15) umfaßt, gebildet aus zwei Halbgehäusen (15A, 15B) in Glockenform, die gemäß einer gemeinsamen Achse (A) ausgerichtet sind und in der Lage sind, in dichtender Weise mit Bezug zueinander durch ihre Mündung in Anlage oder Anhaftung gebracht zu werden, wobei an deren Schnittstelle ein Substratträger (16) vorgesehen ist, und von denen zumindest eine (15B) beweglich ist, um Zugriff auf den Substratträger (16) zu gewähren, wobei für jedes Halbgehäuse (15A, 15B) eine Einspritzeinrichtung (18A, 18B) zur Einwirkung eines Plasmas (12A, 12B) und eine Diffusionseinrichtung (19A, 19B), zumindest zum Zwecke der Diffusion des Vorläuferfluids vorgesehen sind, und daß für jedes Halbgehäuse (15A, 15B) die Einspritzeinrichtung (18A, 18B) ausgebildet ist durch ein Rohr, welches axial angeordnet ist, wobei die Diffusions- oder Verteilungseinrichtung (19A, 19B) zumindest einen Ring (13A, 13'A, 13B, 13'B) umfaßt, wobei der Ring hohl und koaxial zum Einspritzrohr (18A, 18B) vorliegt, wobei der Ring, örtlich Bohrungen (45) aufweisend, sein Innenvolumen angeschlossen an eine Zufuhrkanalisation (46A, 46'A, 46B, 46'B) aufweist und ausgebildet ist bei einem Abstand des Substratträgers (16), und zwar parallel diesbezüglich.

8. Verwendung eines Gerätes nach Anspruch 7, wobei das Gerät **dadurch gekennzeichnet ist, daß** das bewegliche Halbgehäuse (15B) gleitfähig an Schienen (30) montiert ist, die parallel zur Achse (A) verlaufen, gemäß welcher es mit dem anderen Halbgehäuse (15A) ausgerichtet ist.

9. Verwendung eines Gerätes nach einem der Ansprüche 7, 8, wobei das Gerät **dadurch gekennzeichnet ist, daß** das andere Halbgehäuse (15A) feststehend ist.

10. Verwendung eines Gerätes nach einem der Ansprüche 7 bis 9, wobei das Gerät **dadurch gekennzeichnet ist, daß** der Substratträger (16) von einem Isolationsschirm (31) gestützt ist, eingeführt in dichtender Weise zwischen den zwei Halbgehäusen (15A, 15B), wobei der Isolationsschirm (31) in dem zentralen Abschnitt davon eine Öffnung (32) aufweist, durch welche hindurch der Substratträger (16) wirkt.

11. Verwendung eines Gerätes nach einem der Ansprüche 7 bis 10, wobei das Gerät **dadurch gekennzeichnet ist, daß** der Substratträger (16) sich in vertikaler Richtung erstreckt.

12. Verwendung eines Gerätes nach einem der Ansprüche 7 bis 11, wobei das Gerät **dadurch gekennzeichnet ist, daß** an seinem inneren Ende das die Einspritzeinrichtung (18A, 18B) ausbildende Rohr mit einem Divergent oder einer Divergiereinrichtung (37) ausgestattet ist.

13. Verwendung eines Gerätes nach einem der Ansprüche 7 bis 12, wobei das Gerät **dadurch gekennzeichnet ist, daß** außerhalb von jedem Halbgehäuse (15A, 15B) das die Einspritzeinrichtung (18A, 18B) ausbildende Rohr von einem Exikator (41) umgeben ist.

14. Verwendung eines Gerätes nach einem der Ansprüche 7 bis 13, wobei das Gerät **dadurch gekennzeichnet ist, daß** die Diffusions- oder Verteilungseinrichtung (19A, 19B) zumindest zwei Ringe (13A, 13'A, 13B, 13'B) umfaßt, die parallel zueinander vorliegen.

## Claims

1. A method of depositing at least one thin layer onto a double-sided substrate, of the kind using a plasma in cooperation with at least one precursor fluid the reaction products of which in the plasma give rise to the required deposit, and wherein two separate plasmas (12A, 12B) are used for simultaneous treatment of both faces (11A, 11B) of the substrate (10), one on the same side as one of said faces (11A, 11B) and the other on the same side as the other of the latter, **characterized in that**, for treating an organic material substrate (10), the substrate (10) is kept outside the plasma by a "post-discharge" treatment.

2. A method according to claim 1, **characterized in that** two plasmas (12A, 12B) are used, the parameters of which are identical.

3. A method according to either claim 1 or claim 2, **characterized in that** the plasmas (12A, 12B) are pulsed.

4. A method according to any of claims 1 to 3, **characterized in that**, in the case of a substrate (10) in the form of a disc, at least one ring (13A, 13'A, 13B, 13'B) at a distance from the substrate (10), globally parallel to the latter and adapted to diffuse the precursor fluid, is used to apply the precursor fluid.

5. A method according to any of claims 1 to 4, **characterized in that** the electrical discharge creating the plasma (12A, 12B) is excited at microwave frequencies.

6. A method according to any of claims 1 to 4, **characterized in that** the electrical discharge creating the plasma (12A, 12B) is excited at radio frequencies.

7. The use, for carrying out a method according to any of claims 1 to 6, of apparatus **characterized in that** it includes a treatment chamber (15) formed of two bell-shaped half-chambers (15A, 15B) aligned along a common axis (A) and adapted to have their open ends pressed together and sealed to each other with a substrate holder (16) at the interface between them and at least one of which (15B) is mobile to provide access to said substrate holder (16), with an injector device (18A, 18B) for each half-chamber (15A, 15B) for the use of a plasma (12A, 12B) and a diffuser device (19A, 19B) for the use of at least one precursor fluid, and **in that**, for each half-chamber (15A, 15B), the injector device (18A, 18B) is formed by an axial tube and the diffuser device (19A, 19B) includes at least one hollow ring (13A, 13'A, 13B, 13'B) which is coaxial with the injector tube (18A, 18B) and has holes (45) from place to place connecting its interior volume to a supply pipe (46A, 46'A, 46B, 46'B) and is at a distance from and parallel to the substrate holder (16).

8. The use according to claim 7 of apparatus **characterized in that** the mobile half-chamber (15B) slides on rails (30) parallel to the axis (A) along which it is aligned with the other half-chamber (15A).

9. The use according to claim 7 or claim 8 of apparatus **characterized in that** the other half-chamber (15A) is fixed.

10. The use according to any of claims 7 to 9 of apparatus **characterized in that** the substrate holder (16) is carried by an insulative screen (31) between and sealed to the two half-chambers (15A, 15B), said insulative screen (31) having an opening (32) in its central area through which the substrate holder (16) passes.

11. The use according to any of claims 7 to 10 of apparatus **characterized in that** the substrate holder (16) is vertical.

12. The use according to any of claims 7 to 11 of apparatus **characterized in that** at its inside end the tube forming the injector device (18A, 18B) has a divergent end (37).

13. The use according to any of claims 7 to 12 of apparatus **characterized in that** the tube forming the injector device (18A, 18B) is surrounded by an exciter (41) outside each half-chamber (15A, 15B).

14. The use according to any of claims 7 to 13 of apparatus **characterized in that** the diffuser device (19A, 19B) includes at least two parallel rings (13A, 13'A, 13B, 13'B).
